# EUROPEAN PATENT SPECIFICATION

(11) **EP 1 537 659 B1**
(45) Date of publication and mention of the grant of the patent: **21.05.2008**
(21) Application number: 03738378.3
(22) Date of filing: 27.06.2003
(51) Int. Cl.: H03H 11/18, H03D 7/16, H03D 3/00

(54) **TUNING ARRANGEMENT**
ABSTIMMVORRICHTUNG
DISPOSITIF D'AJUSTEMENT

(30) Priority: 04.07.2002 EP 02014792
(43) Date of publication of application: 08.06.2005
(73) Proprietor: NXP B.V., 5656 AG Eindhoven (NL)
(72) Inventor: Stikvoort, Eduard, Ferdinand c/o Philips Intellectual Property & Standards GmbH, 52066 Aachen (DE); Van Sinderen, Jan c/o Philips Intellectual Property & Standards GmbH, 52066 Aachen (DE); Tombeur, Antoon c/o Philips Intellectual Property & Standards GmbH, 52066 Aachen (DE); Jeurissen, Gerardus c/o Philips Intellectual Property & Standards GmbH, 52006 Aachen (DE); Notten, Marc c/o Philips Intellectual Property & Standards GmbH, 52066 Aachen (DE)
(74) Representative: van der Veer, Johannis Leendert
(86) International application number: PCT/IB2003/002496
(87) International publication number: WO 2004/006433

(56) References cited:
- WO-A-01/28310
- WO-A-02/093732
- US-A- 3 581 122
- TOM HORNAK: "Using polyphase filters as image attenuators" RF DESIGN, CARDIFF PUBLISHING CO, ENGLEWOOD,CO, US , June 2001 (2001-06), pages 26-34, XP001073227

## Description

The invention relates to a tuning arrangement for receiving a plurality of signal channels and for tuning to a specific of said plurality of signal channels, the arrangement comprising a polyphase mixer for mixing said specific signal channel to an intermediate frequency which is lower than twice the bandwidth of the channel, a polyphase IF filter for rejecting the negative frequencies in the mixer output signal and a polyphase group delay equalizer connected to the output of the polyphase IF filter. Such a tuning arrangement, which is proposed in figure 6 of applicant's prior international patent publication WO 02/093732, has the advantage that the tuning arrangement can be implemented with a high degree of monolithic integration without many discrete components and without the costs involved in adjusting such discrete components.

In most applications of a tuning arrangement of the above kind the group delay has to be kept within certain limits. For instance, in analogue TV a delay results in a horizontal shift in the picture and one pixel shift approximately corresponds with a delay of 80 ns. Therefore it is necessary that the variations in the group delay be kept below 80 ns. This is why the above-described tuning arrangement is equipped with a group delay equalizer.

Usually, prior art group delay equalizers have an all pass transfer function with pole-zero pairs which lie symmetrically with respect to the real axis of the complex frequency plane, with the poles and zeros of the pairs lying symmetrically about the imaginary axis of that plane, whereby the poles are located in the left half of the plane and the zeros in the right half. With other words, with a group delay equalizer with two pole-zero pairs, the two poles are located at p = -σ ± jωₛ and the two zeros are located at p = σ ± jωₛ where ωₛ represents the shift along the imaginary axis and σ the shift along the real axis.

The present invention makes use of the fact that in case of a group delay equalizer for a low IF tuning arrangement a substantial improvement can be obtained when in accordance with the invention the tuning arrangement is characterized in that the transfer function of the group delay equalizer has, for the frequency range of interest, only one or more pole-zero pairs alongside of the positive imaginary axis of the complex frequency plane with the pole(s) and the zero(s) of said one or more pairs lying substantially symmetrically about said positive imaginary axis. Therefore according to the invention, in case the equalizer has only one pole-zero pair, the pole lies at -σ + jωₛ and the zero at σ + jωₛ.

The invention is based on the following recognition: At the lower frequencies the group delay of the low IF filter is high and decreases with increasing frequency. The equalizer group delay originating from the pole-zero pair(s) in the upper half of the complex frequency plane increases with increasing frequency and is therefore able to at least partly correct or equalize the group delay variations of the IF filter. However, the group delay originating from the pole-zero pair(s) in the lower half of the complex frequency plane decreases with increasing frequency. Therefore such pole-zero pair(s) is not only useless for the equalization process but even counteracts this process. Consequently, it is better to avoid any pole-zero pair in the lower half of the complex frequency plane, what is very well possible with a polyphase group delay equalizer.

A preferred embodiment of a group delay equalizer for use in a tuning arrangement according to the invention is characterized in that said polyphase group delay equalizer comprises an in phase part and a quadrature phase part, each of said parts comprising a balanced operational amplifier, first conductances and first capacitances connected in parallel between each output and the inverting input of the operational amplifier for constituting the pole in the complex frequency plane, second conductances between each input of the part and one of the inputs of the operational amplifier and second capacitances between each input of the part and the other of the inputs of the operational amplifier for constituting the zero in the complex frequency plane and further conductances connecting the inputs of the operational amplifier of each part to the inputs and to the outputs of the other of said parts for shifting the pole and the zero along the positive imaginary axis of the complex frequency plane. In case the amplitude of the transfer function is equal to unity, the said first and second capacitances are equal, the said first and second conductances are equal and said further conductances are equal. Compared with conventional group delay equalizers the advantages of this kind of group delay equalizers are: less noise contribution, less power consumption and less chip-area or better performance with unchanged chip area. Moreover this kind of group delay equalizers is easy to design. The group delay curve as a function of the frequency is a symmetrical "hill" with the shape of the "hill" being determined by said first and second conductances and the position of the "hill" being determined by said further conductances.

In some cases the group delay to be equalized may be corrected by a group delay equalizer having only one pole-zero pair in the upper half of the complex frequency plane. In case the group delay to be equalized is larger or more complicated, this group delay may be equalized by an equalizer having two or three pole-zero pairs in the upper half of the complex frequency plane. However, in accordance with another aspect of the invention, a tuning arrangement having such larger or more complicated group delay to be equalized may preferably be characterized in that a cascade of group delay equalizers is connected to the output of the polyphase IF filter, each of said group delay equalizers having only one pole-zero pair alongside of the positive imaginary axis of the complex frequency plane.

The invention will now be described with reference to the accompanying drawings. Herein shows
Fig. 1 a block schematic diagram of a tuning arrangement according to the invention,
Fig. 2a detailed schematic diagram of the group delay equalizer for use in the tuning arrangement of figure 1,
Fig. 3 a pole-zero diagram of the transfer function of the group delay equalizer as depicted in figure 2 and
Fig. 4 graphs showing the course of the group delay as a function of the frequency of different parts of the arrangement of figure 1.

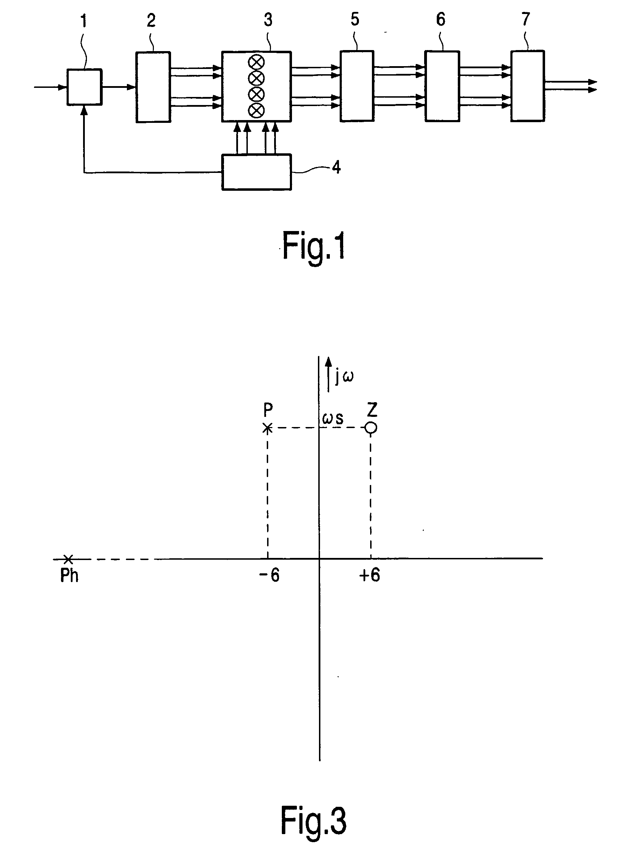

The arrangement of figure 1 is primarily intended for the reception of cable- TV-signals. The arrangement comprises an RF band pass filter 1 which is preferably constituted by a bank of fixed tuned filters, each of which can be switched into operation by a switching signal that is dependent on the local oscillator tuning. Because the mixing process, to be described hereafter, is performed by multiplying the RF-signal with a symmetrical local oscillator square wave that comprises the uneven harmonics of the local oscillator frequency, it is the primary purpose of the RF band pass filter to suppress the 5^{th} harmonic of the RF-signal by about 50 dB. Suppression of the 3^{rd} harmonic is not necessary because the mixing product of the RF 3^{rd} harmonic and the local oscillator 3^{rd} harmonic is cancelled in the polyphase mixer.

In an RF polyphase filter 2 the output of the RF band pass filter 1 is converted into a polyphase RF signal whose negative frequencies are suppressed and this polyphase RF signal is subsequently mixed with a polyphase balanced local oscillator signal from a frequency synthesizer 4 in a full polyphase mixer 3. In the mixer 3 the selected channel is converted to a low IF TV-signal of e.g. 1,5 to 6,4 MHz with the picture carrier at 5,7 MHz.

An IF polyphase filter 5 realizes the larger part of the channel selectivity and moreover suppresses the negative frequencies between -8 and -1 MHz to about -60 dB. The IF output of this filter is applied, through a polyphase group delay equalizer 6 to be described hereafter, to an anti aliasing filter 7 whose primary purpose is to suppress the undesired higher frequencies (> 8 MHz) that would otherwise give rise to aliasing distortion in the AD-converter to follow (not shown). From the anti aliasing filter 7 non-polyphase signals are outputted.

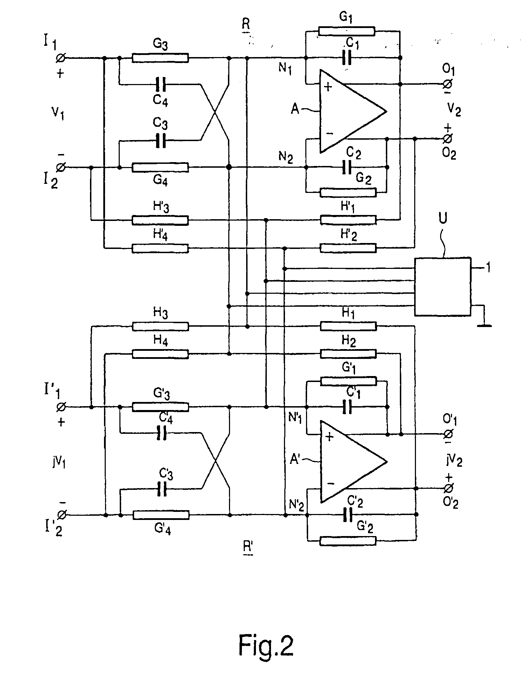

The polyphase group delay equalizer of figure 2 comprises two identical parts R and R'. The part R has input terminals I₁ and I₂ receiving an input signal V₁ to be equalized and output terminals O₁ and O₂ delivering the equalized output signal V₂. The part R' receives at its input terminals I'₁ and I'₂ the same but 90° phase shifted input signal jV₁ and delivers at its output terminals O'₁ and O'₂ the 90° phase shifted output signal jV₂. The elements of the part R' are indicated by the same reference numerals as those of part R except that they are provided with an accent.

The part R comprises a balanced operational amplifier A. The output terminals of the amplifier are each connected through a parallel arrangement of a conductance G₁, G₂ and a capacitance C₁, C₂ to the respective inverting input N₁, N₂ of the operational amplifier. The input terminals I₁ and I₂ are connected through conductances G₃, G₄ to the amplifier inputs N₁, N₂ respectively. Moreover these input terminals are cross-connected through capacitances C₄, C₃ to the amplifier inputs N₂, N₁ respectively.

The conductances G₁ and G₂ have equal values and the same applies to the capacitances C₁ and C₂. The parallel arrangements G₁-C₁ and G₂-C₂ generate a pole P in the complex frequency plane representing the transfer function V₂/N₁ (see figure 3). In this plane the quotient G₁/C₁ = G₂/C₂ = σ is the distance of the pole to the imaginary axis. Similarly the conductances G₃ and G₄ have equal values and the capacitances C₃ and C₄ have equal values. The arrangements G₃-C₃ and G₄-C₄ generate a zero Z in the complex frequency plane of V₂/V₁ (see figure 3), however, because of the cross connection of the two capacitances, this zero lies at the right hand side of the imaginary axis while the pole lies at the left hand side of this axis. The quotient G₃/C₃ = G₄/C₄ determines the distance of the zero to the imaginary axis. For the equalizer to have a uniform amplitude characteristic (all pass) it is necessary that the pole and the zero lie symmetrically about the imaginary axis and this requirement implies that G₁/C₁ = G₂/C₂ = G₃/C₃ = G₄/C₄ = σ. The amplitude (gain) of the group delay equalizer equals unity when all four conductances have equal values G and all four capacitances have equal values C whereby the quotient G/C = σ determines the distance of the pole and the zero to the imaginary axis.

The arrangement described so far is not able to perform the required equalization. This is because the pole and the zero then both lie on the real axis of the complex frequency plane with the result that the group delay is largest at zero frequency and decreases with increasing frequency, while also the group delay to be equalized is maximal at zero frequency. Therefore the arrangement of figure 2 further comprises four conductances H₁, H₂, H₃ and H₄ which are connected respectively between the amplifier input N₁ and the part R' output O'₂, the amplifier input N₂ and the part R' output O'₁, the amplifier input N₁ and the part R' input I'₁ and between the amplifier input N₂ and the part R' input I'₂. The conductances H₁ and H₂ are equal and cause extra currents flowing to the amplifier inputs N₁ and N₂ respectively and these extra currents cause a shift of the pole P along the positive imaginary axis over a distance H₁/C₁ = H₂/C₂. Also the conductances H₃ and H₄ are equal and cause extra currents flowing to the amplifier inputs N1 and N2 respectively. These cause a shift of the zero Z along the positive imaginary axis of the plane over a distance H₃/C₃ = H₄/C₄. For the equalizer to retain its all pass character these shifts have to be equal so that H₁/C₁ = H₂/C₂ = H₃/C₃ = H₄/C₄ = ωₛ (see figure 3). Of course when all four capacitances are equal also all four conductances have to be equal and the shift ωₛ = H/C.

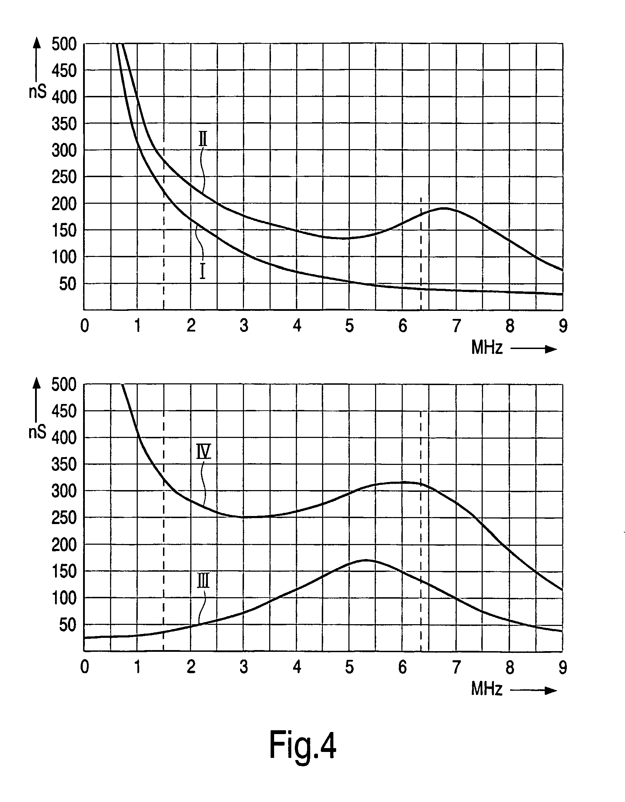

Figure 4 shows the result of the group delay equalizing by means of the equalizer constructed and dimensioned as described with reference to figures 1, 2 and 3. Curve I shows the group delay of the polyphase IF filter 5 as function of the frequency. The group delay equalizer 6 not only equalizes the group delay of the IF filter 5 but also of the anti aliasing filter 7. Therefore curve II of figure 4 depicts the total group delay of the two units 5 and 7. Vertical stroke lines indicate the limits of the frequency range of the low IF TV signal to be handled. It can be seen from curve II that the group delay of the two units varies between 130 and 290 ns.

Curve III of figure 4 shows the group delay of the polyphase group delay equalizer 6. This curve is a symmetrical "hill" with a top of 170 ns at 5,4 MHz. It may be noted that, with given capacitances, the shape of the "hill" is determined only by σ i.e. by the G-conductances of the equalizer and that the position of the "hill" is determined only by ωₛ i.e. by the H-conductances of the equalizer.

Curve IV of figure 4 shows the total equalized delay that is the sum of the curves II and III. This delay ranges from 325 ns at 1,5 MHz till 250 ns at 3 MHz, i.e. the delay variation is 75 ns, which is within the limit of 80 ns set before.

As has already been mentioned in the preamble, more than one group delay equalizer can be connected in cascade so that the group delay of the individual equalizers is added. The individual equalizers may have the same or different pole-zero patterns.

## Claims

1. A tuning arrangement for receiving a plurality of signal channels and for tuning to a specific one of said plurality of signal channels, the arrangement comprising a polyphase mixer (3) for mixing said specific signal channel to an intermediate frequency which is lower than twice the bandwidth of the channel, a polyphase IF filter (5) for rejecting the negative frequencies in the mixer output signal and a polyphase group delay equalizer (6) connected to the output of the polyphase IF filter,
**characterized in that** the transfer function of the group delay equalizer has, for the frequency range of interest, only one or more pole-zero pairs (P-Z) in the positive imaginary part of the complex frequency plane with the pole(s) (P) and the zero(s) (Z) of said one or more pairs lying substantially symmetrically about the positive imaginary axis of the complex frequency plane.

2. A tuning arrangement as claimed in claim 1, **characterized in that** said polyphase group delay equalizer comprises an in phase part (R) and a quadrature phase part (R'), each of said parts comprising a balanced operational amplifier (A), first conductances (G₁, G₂) and first capacitances (C₁, C₂) connected in parallel between each output and its respective inverting input of the operational amplifier (A) for constituting the pole (P) in the complex frequency plane, second conductances (G₃, G₄) between each input (I₁), I₂) of the part and one of the inputs (N₁, N₂) of the operational amplifier and second capacitances (C₃, C₄) between each input (I₁, I₂) of the part and the other of the inputs (N₂, N₁) of the operational amplifier for constituting the zero in the complex frequency plane and further conductances (H₁...H₄) connecting the inputs (N₁, N₂) of the operational amplifier of each part to the inputs (I'₁, I'₂) and to the outputs (O'₁, O'₂) of the other of said parts for shifting the pole and the zero along the positive imaginary axis of the complex frequency plane.

3. A tuning arrangement as claimed in claim 1, **characterized in that** a cascade of group delay equalizers is connected to the output of the polyphase IF filter, each of said group delay equalizers having only one pole-zero pair in the positive imaginary part of the complex frequency plane.

## Patentansprüche

1. Eine Abstimmvorrichtung zum Empfangen einer Mehrzahl von Signalkanälen und zum Abstimmen auf einen spezifischen Signalkanal, der zu besagter Mehrzahl von Signalkanälen gehört, wobei die Vorrichtung einen Mehrphasenmischer (3) zum Mischen besagten spezifischen Signalkanals auf eine Zwischenfrequenz, die niedriger als die doppelte Bandbreite des Kanals ist, ein Mehrphasen-ZF-Filter (5) zum Sperren der negativen Frequenzen in dem Mischerausgangssignal und einen Mehrphasen-Gruppenlaufzeitentzerrer (6), der an den Ausgang des Mehrphasen-ZF-Filters angeschlossen ist, umfasst,
**dadurch gekennzeichnet, dass** die Übertragungsfunktion des Gruppenlaufzeitentzerrers, für den Frequenzbereich von Interesse, ein oder mehrere Pol/Nullstellen-Paar/e (P-Z) in dem positiven imaginären Teil der komplexen Frequenzebene hat, wobei der/die Pol/e (P) und die Nullstelle/n (Z) besagten einen Paars oder besagter mehrerer Paare im Wesentlichen symmetrisch um die positive imaginäre Achse der komplexen Frequenzebene herum liegen.

2. Eine Abstimmvorrichtung nach Anspruch 1, **dadurch gekennzeichnet, dass** besagter Mehrphasen-Gruppenlaufzeitentzerrer einen Inphase-Teil (R) und einen Quadraturphase-Teil (R') umfasst, wobei jeder der besagten Teile einen symmetrischen Operationsverstärker (A), erste Konduktanzen (G₁, G₂) und erste Kapazitäten (C₁, C₂), die zwischen jedem Ausgang und seinem jeweiligen invertierenden Eingang des Operationsverstärkers (A) zum Bilden des Pols (P) in der komplexen Frequenzebene parallel geschaltet sind, zweite Konduktanzen (G₃, G₄) zwischen jedem Eingang (I₁, I₂) des Teils und einem der Eingänge (N₁, N₂) des Operationsverstärkers und zweite Kapazitäten (C₃, C₄) zwischen jedem Eingang (I₁, I₂) des Teils und dem anderen der Eingänge (N₂, N₁) des Operationsverstärkers zum Bilden der Nullstelle in der komplexen Frequenzebene und weitere Konduktanzen (H₁...H₄), die die Eingänge (N₁, N₂) des Operationsverstärkers jedes Teils an die Eingänge (I'₁, I'₂) und an die Ausgänge (O'₁, O'₂) des anderen der besagten Teile zum Verschieben des Pols und der Nullstelle entlang der positiven imaginären Achse der komplexen Frequenzebene anschließen, umfasst.

3. Eine Abstimmvorrichtung nach Anspruch 1, **dadurch gekennzeichnet, dass** eine Kaskade von Gruppenlaufzeitentzerrem an den Ausgang des Mehrphasen-ZF-Filters angeschlossen ist, wobei jeder der besagten Gruppenlaufzeitentzerrer nur ein Pol/Nullstellen-Paar in dem positiven imaginären Teil der komplexen Frequenzebene hat.

## Revendications

1. Dispositif de réglage ou de syntonisation pour recevoir une pluralité de canaux de signaux et pour se régler sur un canal spécifique de ladite pluralité de canaux de signaux, le réglage comprenant un mélangeur polyphasé (3) pour mélanger ledit canal de signaux spécifiques à une fréquence intermédiaire qui est inférieure à deux fois la largeur de bande du canal, un filtre IF polyphasé (5) pour rejeter les fréquences négatives dans le signal de sortie du mélangeur et un égalisateur de retard de groupe polyphasé (6) connecté à la sortie du filtre IF polyphasé,
**caractérisé en ce que** la fonction de transfert de l'égalisateur de retard de groupe comporte, pour la plage de fréquences d'intérêt, uniquement une ou plusieurs paires zéro pôle (P-Z) dans la partie imaginaire positive du plan de fréquence complexe avec le ou les pôles (P) et le ou les zéros (Z) d'une ou de plusieurs paires situées sensiblement symétriquement sur l'axe imaginaire positif du plan de fréquence complexe.

2. Dispositif de réglage tel que défini dans la revendication 1, **caractérisé en ce que** ledit égalisateur de retard de groupe polyphasé comprend une partie en phase (R) et une partie en phase de quadrature (R'), chacune desdites parties comprenant un amplificateur opérationnel équilibré (A), des premières conductances (G₁, G₂) et des premières capacitances (C₁, C₂) connectées en parallèle entre chaque sortie et son entrée d'inversion respective de l'amplificateur opérationnel (A) pour constituer le pôle (P) dans le plan de fréquence complexe, les secondes conductances (G₃, G₄) entre chaque entrée (I₁, I₂) de la partie et l'une des entrées (N₁, N₂) de l'amplificateur opérationnel et secondes capacitances (C₃, C₄) entre chaque entrée (I₁, I₂) de la partie et de l'autre des entrées (N₂, N₁) de l'amplificateur opérationnel pour constituer le zéro dans le plan de fréquence complexe et d'autres conductances (H₁... H₄) connectant les entrées (N₁, N₂) de l'amplificateur opérationnel de chaque partie des entrées (I'₁, I'₂) et aux sorties (O'₁, O'₂) de l'autre desdites parties pour décaler le pôle et le zéro le long de l'axe imaginaire positif du plan de fréquence complexe.

3. Dispositif de réglage tel que défini dans la revendication 1, **caractérisé en ce qu'**une cascade d'égalisateurs de retard de groupe est connectée à la sortie du filtre IF polyphasé, chacun desdits égalisateurs de retard de groupe ayant uniquement une paire pôle-zéro dans la partie imaginaire positive du plan de fréquence complexe.
